# FASCICULE DE BREVET EUROPEEN

(11) **EP 1 669 766 B1**
(45) Date de publication et mention de la délivrance du brevet: **17.01.2007**
(21) Numéro de dépôt: 05301017.9
(22) Date de dépôt: 06.12.2005
(51) Int. Cl.: G01R 31/00, G01R 29/08, H01Q 13/02

(54) **Sonde de test de circuit intégré**
Testsonde mit integriertem Schaltkreis
Test probe for an integrated circuit

(30) Priorité: 07.12.2004 FR 0452895
(43) Date de publication de la demande: 14.06.2006
(73) Titulaire: European Aeronautic Defence and Space Company - EADS France, 75116 Paris (FR); EADS CCR, 75116 Paris (FR)
(72) Inventeur: Maurice, Olivier, 91140, Villebon sur Yvette (FR)
(74) Mandataire: Schmit, Christian Norbert Marie

(56) Documents cités:
- WO-A-00/72030
- DE-C- 19 501 329
- US-A1- 2002 047 722

## Description

La présente invention a pour objet une sonde de test de circuit intégré utilisée notamment pour la caractérisation en compatibilité électromagnétique des circuits intégrés.

Les techniques de caractérisation de l'immunité des composants en circuits intégrés actuellement connues se regroupent en deux familles principales : les techniques dites à injection directe, et les techniques dites à injection rayonnée.

Les techniques à injection directe sont elles-mêmes séparées en deux types principaux : la technique DPI (Direct Power Injection - Injection directe de courant), et la technique BCI (Bulk Current Injection - Injection globale de courant). La technique DPI consiste à élaborer un circuit imprimé spécifique pour le composant, auquel on vient ajouter des possibilités d'injection d'un signal parasite. On regarde ensuite si le composant est perturbé en présence du signal injecté. La technique BCI consiste à insérer un câble qui transporte les signaux fonctionnels du composant, ou d'une carte qui porte plusieurs composants, dans un transformateur. Le transformateur a pour but d'injecter de la puissance électrique sur des brins conducteurs de ce câble, et par ce biais de vérifier la perturbation ou la non perturbation du (des) composant(s).

La technique DPI a pour avantage une caractérisation fine de la susceptibilité d'une fonction d'un circuit intégré, pour une injection localisée. Son défaut est de ne pas permettre facilement une injection simultanée sur plusieurs entrées d'un composant. A l'inverse la technique BCI autorise d'agresser simultanément tous les accès d'un composant. Mais, la technique BCI utilisant des fils de liaisons de longueur minimale du fait même du volume du transformateur, elle ne permet pas de monter haut en fréquence, en pratique pas au dessus de 500 MHz.

Les techniques à injection rayonnée utilisent des cellules résonantes TEM (Transverse Electromagnétique Mode), ou GTEM (Gigahertz TEM), ou encore des cellules à mode agité MSC (Mode Stirred Chamber), pour exciter des cartes électroniques du type circuit imprimé qui portent les composants.
Le document DE-C1-195 01 329 divulgue une cellule TEM pour la caractérisation en compatibilité électromagnétique des appareils électriques.
Ou bien, ces cellules excitent des cartes spécifiques portant un composant à tester pour vérifier sa susceptibilité sous champ. Dans tous les cas, pour caractériser la susceptibilité d'un composant ces techniques demandent la fabrication d'une carte particulière, et nécessitent, du fait de l'éloignement relatif des sources de champ avec les composants, des sources de puissance importantes. En outre, la maîtrise de la part de puissance perturbatrice effectivement reçue par le composant n'est pas facile, voire discutable.

L'invention a ainsi pour objectif de permettre une caractérisation in situ de la susceptibilité d'un circuit intégré en très hautes fréquences. Elle comporte dans son principe une structure de guidage du champ perturbateur sur une zone particulière, petite, autour d'un composant tel qu'il se présente dans la réalité. Ainsi, un tel composant peut être testé seul dans son propre boîtier ou encore monté sur une carte électronique avec laquelle il doit être réellement utilisé (pas une carte spécifique de test).

La structure de guidage du champ perturbateur de l'invention comporte, dans un exemple, une structure globalement conique montée en prolongement d'un câble coaxial, avec globalement deux cornets ou entonnoirs imbriqués, deux cônes dans un exemple pratique. Une âme centrale, métallique, en cornet fermé (ou plein), forme en même temps une antenne et un masque de propagation du champ radioélectrique issu du câble. Un cornet enveloppe, de préférence métallique, enveloppe ce cornet masque et canalise le champ propagé sur une zone choisie d'avance. La zone choisie d'avance est une zone périphérique du composant : celle où sont normalement situées les connexions de raccordement de ce composant. Cette zone périphérique correspond à une couronne présente entre les deux cornets.

Cette structure de guidage reçoit l'énergie en provenance d'un câble coaxial, et la dirige de façon rayonnée en champ proche vers le composant. Les champs électriques et magnétiques s'établissent tout autour du cornet masque, et pour le champ électrique, également entre l'extrémité du cornet masque en direction d'un plan de masse qui porte le composant. Ces champs viennent se coupler avec les broches du composant ou les pistes et boules de soudure (bonding dans le cas des boîtiers BGA). La cloche enveloppe peut par ailleurs être disposée sur les deux faces du circuit imprimé. Son développement ne demande éventuellement qu'une faible épargne autour du composant. De préférence, cette épargne est réalisée avec une piste de masse reliée à la masse du composant à tester. Cette épargne correspond à la zone périphérique de contact avec la cloche point froid. Cette épargne peut être facilement incluse dans le routage final et fonctionnel de la carte incluant le composant. La technique permet ainsi d'évaluer la susceptibilité d'un composant dans son environnement de travail réel, en prenant en compte les couplages avec les éléments proches indissociables du composant. Parmi ces éléments indissociables figurent des éléments de découplages éventuels, des pistes, des boîtiers ou autre. Il est aussi possible d'utiliser une version du cornet enveloppe, isolée à son extrémité inférieure. Cette version autorise un appui de ce cornet enveloppe sur les composants proches dans la périphérie du composant à tester. Une jupe souple conductrice vient alors s'appuyer sur ces composants (condensateurs de découplages, quartz, ...), continuant de confiner le champ sur la zone à irradier, mais sans imposer la fabrication d'un routage spécifique avec l'épargne pour masse.

La puissance transmise totale est mesurée par l'intermédiaire d'un coupleur mis en ligne avec le câble d'alimentation de la cloche. L'avantage de la technique est de ne pas demander la création obligatoire d'une carte de test spécifique, et de prendre en compte les conditions réelles de fonctionnement du circuit intégré. Le champ est certes polarisé suivant certaines directions, mais la perturbation hyperfréquence des composants, surtout basée sur les phénomènes de détection, ne prend pas en compte la phase relative des injections d'une entrée à l'autre. Elle prend plutôt en compte l'amplitude de champ couplé.

Les formes des cloches peuvent être diverses et adaptées à différentes configurations de circuits imprimés et d'implantation.

L'invention a donc pour objet unesonde de test d'un circuit intégré qui est porté par un circuit imprimé, la sonde comportant un générateur de signaux radiofréquences, une antenne, un circuit d'alimentation pour relier l'antenne au générateur, et des moyens pour disposer l'antenne en regard de connexions situées en périphérie d'un circuit intégré à tester, pour faire rayonner ces signaux radiofréquences sur ces connexions, caractérisé en ce que l'antenne comporte un guide d'onde avec un cornet enveloppe et une âme masque, le cornet enveloppe ayant une surface d'ouverture plus grande qu'une étendue d'une surface d'un boîtier du circuit intégré à tester, l'âme masque ayant un épanouissement dont une surface de section à l'endroit de son extrémité est inférieure à la surface d'un boîtier du circuit intégré à tester, des moyens étant prévu pour placer le cornet enveloppe contre le circuit imprimé, et l'âme masque, à l'intérieur du cornet enveloppe, au dessus du composant.

En particulier le cornet masque peut s'arrêter plus haut dans le volume du cornet enveloppe pour générer des champs de polarisations diverses ou exploiter des effets de cavité dans le volume du cornet enveloppe. Les cornets ne sont par ailleurs pas forcément de forme conique, ils peuvent être de forme parallélépipédique.

L'invention sera mieux comprise à la lecture de la description qui suit et à l'examen des figures qui l'accompagnent. Celles-ci ne sont présentées qu'à titre indicatif et nullement limitatif de l'invention. Les figures montrent:
- Figure 1 : une représentation schématique d'une antenne d'une sonde de test selon l'invention ;
- Figure 2 : un dispositif d'utilisation de la sonde de test selon l'invention ;
- Figures 3, 4 et 6 : des détails de réalisation d'un élément essentiel de la sonde de l'invention.

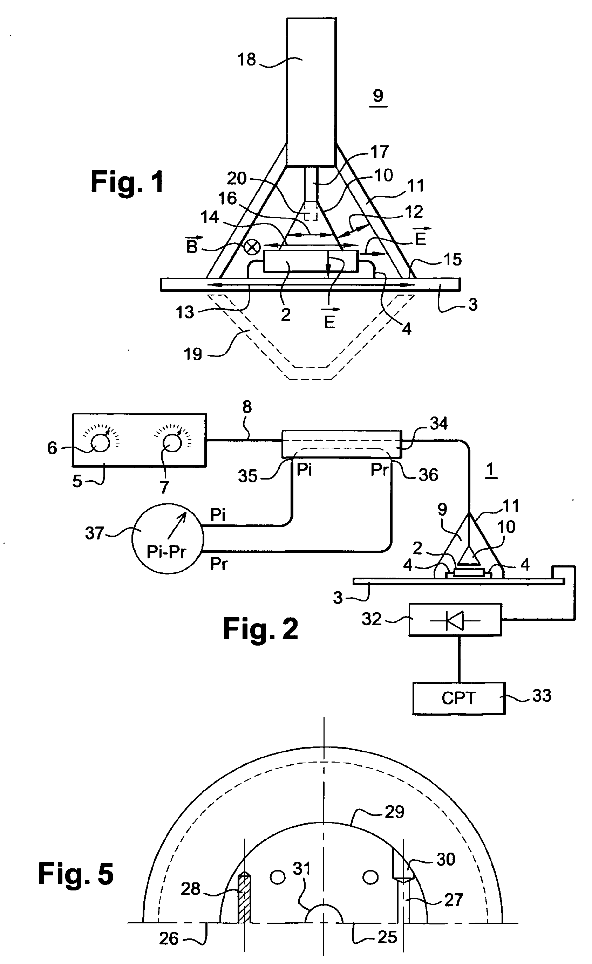

Les figures 1 et 2 montrent une sonde 1 de test d'un circuit intégré 2 selon l'invention. La figure 1 est une vue d'un détail particulier de la figure 2. Un circuit intégré 2 y est porté par un circuit imprimé 3. Par exemple le circuit intégré 2 est relié au circuit imprimé 3 par des connexions 4 par lesquelles il est naturellement alimenté. Le circuit imprimé 3 est de préférence un circuit imprimé réel, celui destiné à porter le composant 2 dans son utilisation réelle, notamment une carte de circuit électronique à insérer dans un appareil dans lequel ce circuit intégré est utile. Au besoin, le circuit imprimé 3 peut être un circuit de test. Ce n'est cependant pas nécessaire avec l'invention. Dans ce cas en particulier, l'invention permet de tester le circuit 2 dans des conditions réelles d'utilisation.

La sonde 1 comporte un générateur 5 de signaux radiofréquences. De préférence, le générateur 5 comporte un circuit 6 pour régler la fréquence d'un signal émis, ainsi qu'un circuit 7 pour régler l'amplitude du signal produit par le générateur 5. Le générateur 5 est relié par un circuit d'alimentation 8 à une antenne 9. L'antenne 9 forme la partie essentielle de l'invention. L'antenne 9 est montrée plus en détail sur la figure 1. L'antenne 9 est disposée en regard du circuit intégré 2 à tester. L'antenne 9 est notamment disposée en regard des connexions 4. D'une manière connue l'antenne 9 sert à faire rayonner des signaux électromagnétiques radiofréquences sur les connexions 4 ainsi que dans le composant 2 et dans le circuit imprimé 3 de manière à venir perturber le fonctionnement du circuit intégré 2, de manière à en mesurer la résistance aux perturbations.

Selon l'invention l'antenne 9 comporte un guide d'ondes capable de rayonner un champ électrique E et un champ magnétique B radiofréquence. Sur la figure 1 le champ électrique E est montré comme orienté, dans les parties utiles, à partir d'une âme masque 10 de l'antenne 9 en direction d'un cornet enveloppe 11 de cette antenne 9, ainsi qu'en direction du circuit imprimé 3 à partir de l'âme masque 10. Le champ magnétique radiofréquence B se propage dans tout l'espace du guide et, notamment, à l'endroit des connexions 4 est orienté dans les directions perpendiculaires à ces connexions. On pourrait montrer que le guide d'ondes ainsi formé, propage en champ proche les champs électrique et magnétique sur le circuit intégré 2. Par conséquent les orientations de ces champs ne sont pas complètement stabilisées. L'orientation du champ B est fluctuante de sorte que pendant une proportion notable du temps le champ B exerce bien une influence perturbatrice recherchée sur les connexions 4.

L'idée de l'invention est de former, avec l'âme masque 10, un guide d'ondes de manière à ce que seul un espace 12 où sont situées les connexions 4 va être excité par le champ radioélectrique radiofréquence. L'espace 12 est l'espace situé à l'intérieur du cornet enveloppe 11, entre ce cornet enveloppe 11 et l'âme masque 10. De ce fait, le cornet enveloppe 11 a une surface d'ouverture 13 plus grande qu'une étendue 14 du circuit intégré 3 à tester et de ses connexions. Dans la mesure du possible, on pourra prévoir que le cornet enveloppe 11 entre en contact avec un circuit de masse 15 périphérique au composant 2 et réalisé sur le circuit imprimé 3. Cependant, cette disposition n'est pas indispensable, il suffit seulement que le cornet enveloppe 11 ait une étendue plus grande que les connexions 4 de manière à ne pas les toucher.

En contrepartie, l'âme masque 10 possède un épanouissement 16 dont une surface de section à l'endroit de son extrémité sur le composant 2 est inférieure à l'étendue 14 de la surface d'un boîtier du circuit intégré 2 à tester.

Autant le cornet enveloppe est plaqué sur le circuit imprimé 3 autant l'âme masque 10 est placée sur le composant, à l'intérieur du cornet enveloppe. Le cornet enveloppe 11 et l'âme masque 10 sont reliés au circuit d'alimentation 8. Dans un exemple, ce circuit d'alimentation 8 comporte un câble coaxial avec une âme 17 et un conducteur extérieur de masse 18, en général une tresse. L'âme masque 10 est reliée au conducteur central 17, le cornet enveloppe 11 est relié à la tresse 18.

En agissant ainsi, on confine le développement du champ radioélectrique dans l'espace 12, notamment celui où sont situées les connexions 4. Au besoin, le cornet enveloppe 11 peut être complété par un deuxième cornet 19 de forme symétrique au premier et placé à l'opposé du circuit imprimé 3. Ce faisant, on transforme, dans tous les cas, le circuit imprimé 3 muni de son circuit intégré 2 en une charge pour le champ rayonné. Comme le champ rayonné ne s'établit pas dans tout l'espace mais entre seulement l'âme masque 10 et le cornet enveloppe 11, à l'endroit des connexions 4 il est bien plus important et bien plus perturbateur (ce qui est le but recherché) que si l'âme masque 10 n'avait pas été présente et si le champ électrique avait pu s'installer librement dans l'espace.

Pour plaquer le cornet enveloppe 11 contre le circuit imprimé 3 en même temps que l'âme masque 10 sur le composant 2, on peut prévoir que l'âme masque possède à son sommet un trou par lequel pénètre d'une manière élastique, avec un degré de liberté en translation, l'âme 17 du câble coaxial de manière à tenir compte des différences d'altitude des surfaces supérieures des composants 2 sur le circuit imprimé 3. Dans la pratique, au cours du test, il peut suffire de tenir le câble coaxial 17-18 à la main au-dessus du circuit imprimé pendant les mesures pour arriver au résultat. Autrement on prévoit une structure complémentaire de manipulation et de maintien.

Bien entendu, le cornet enveloppe 11 et l'âme masque 10 sont formés de préférence avec des surfaces conductrices de l'électricité. Cependant, il serait possible d'en réaliser l'une ou l'autre, voire les deux, avec des matériaux de permittivité très différente de l'air de façon à ce que le phénomène de guide d'ondes préconisé se produise efficacement.

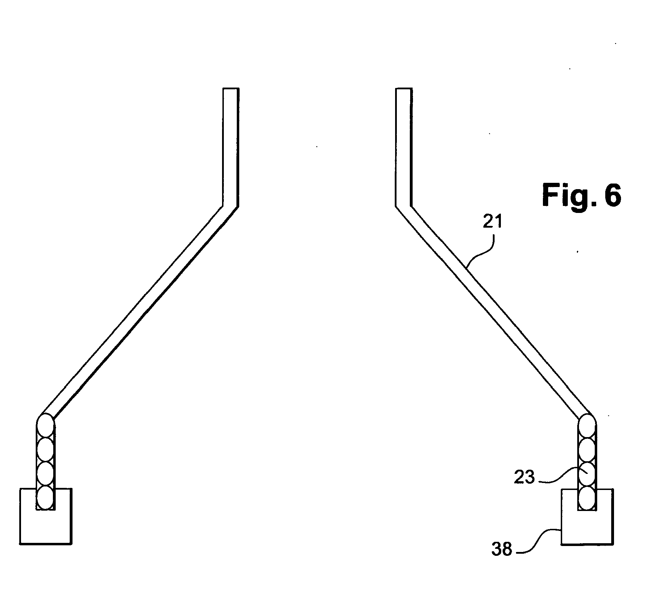

Sur la figure 4, on distingue l'âme masque 10 formée par une tôle et ayant une forme conique fermée à sa base par une surface métallique, continue avec ses flancs. Dans cet exemple l'âme masque 10 possède un épanouissement circulaire dont le diamètre est de l'ordre de 12,3 mm. L'âme masque 10 comporte également à son sommet un trou 20, métallisé sur ses parois, permettant d'y introduire une âme d'un câble coaxial et d'y souder cette âme. En variante, l'âme masque 10 est formée en un matériau métallique plein. Si elle est en tôle, le trou 20 peut être ou non obturé à son extrémité intérieure par un bouchon métallique.

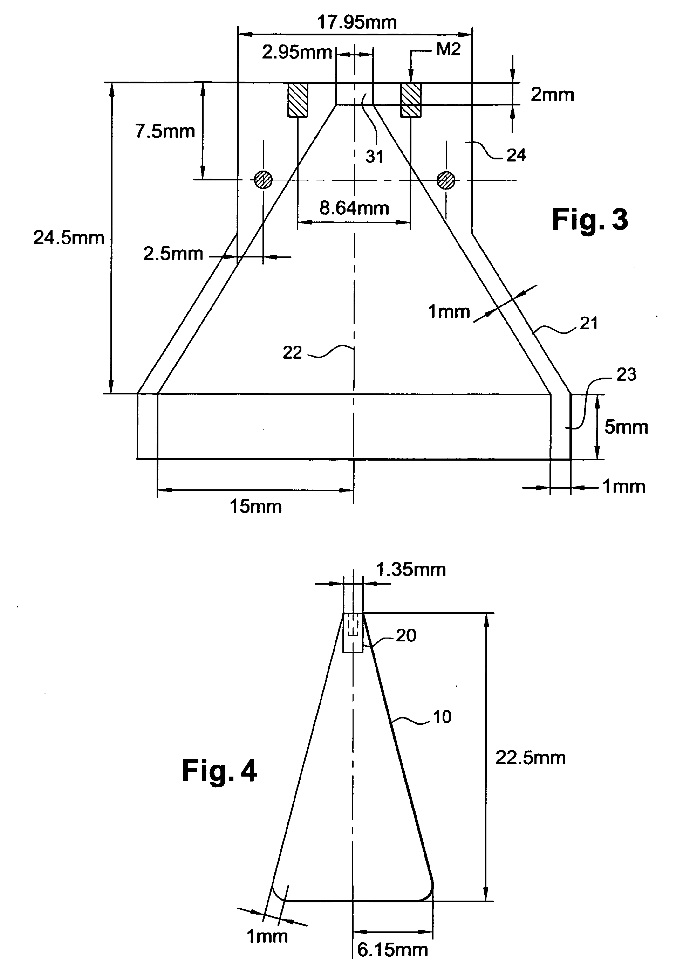

Autant l'âme masque 10 est de préférence réalisée d'une pièce, autant le cornet enveloppe 11 est formé de préférence de deux demi coquilles montrées sur la figure 3. Dans un exemple, ces deux demi coquilles sont fabriquées par moulage ou par estampage. Chaque demi coquille comporte un manteau 21 de forme demi conique centré sur un axe de révolution 22. Le manteau 21 est solidaire à sa base d'une jupe 23 de forme cylindrique circulaire autour de l'axe 22. Le manteau 21 est surmonté d'un col massif 24 de forme extérieure cylindrique et de forme intérieure conique autour de l'axe 22.

La figure 5 montre en coupe chacune des demi coquilles présentées sur la figure 3. Les demi coquilles présentent à l'endroit du col 24 massif des surfaces de plaquage 25 et 26. Dans un exemple la surface 25 est percée d'un percement 27 alors que la surface 26 est taraudée d'un taraudage 28 non débouchant. II pourrait toutefois être débouchant. Le percement 27 comporte à partir de la paroi cylindrique 29 du col, un alésage 30 plus large que le percement 27. Cet alésage 30 permet de maintenir une tête d'une vis coulissant dans le percement 27 et venant se visser dans le taraudage 28 de l'autre demi coquille plaquée contre les faces 25 et 26. Le col 24 comporte également à son sommet une demi ouverture circulaire 31 en demi vasque. La demi ouverture 31 est destinée à venir enserrer la tresse 18 du câble coaxial qui sert à alimenter la sonde.

Le fait d'utiliser des demi coquilles permet, pour une même taille d'âme masque, d'adapter éventuellement des cornets enveloppe de taille et de forme différentes en fonction de l'encombrement ou du déploiement d'un circuit intégré à tester.

Autant les formes montrées jusqu'ici sont des formes coniques, autant il serait possible d'adopter des formes avec des épanouissements mais dont la section de base ne serait pas circulaire mais éventuellement rectangulaire, carrée, ou autre, en fonction de la forme des circuits intégrés à tester. Bien entendu les indications chiffrées données sur les figures 3 et 4 peuvent être adaptées à la taille des circuits intégrés à tester. Les demi coquilles sont formées de part et d'autre d'un plan passant par l'axe 22. Elles sont symétriques par rapport à ce plan. La demi ouverture 31 est métallisée de manière à assurer un bon contact sur la tresse 18.

Sur la figure 6, en variante, la jupe 23 est réalisée sous la forme d'un tricot métallique déformable et conducteur. Ce tricot métallique, connecté au manteau métallique 21, canalise le champ. Si une épargne de masse n'est pas réalisée sur le circuit imprimé qui porte le circuit intégré à tester, le bord inférieur de la jupe 23 en tricot est muni d'un joint isolant 38, par exemple en caoutchouc, par exemple amovible. Le profil du joint 38 est en forme de U. L'écart des branches du U est suffisamment étroit pour maintenir le joint 38 par élasticité à la base de la jupe sur laquelle il est engagé.

Le fonctionnement de la sonde de l'invention est le suivant. Figure 1, avec le générateur 5 et au moyen de l'antenne 9, des signaux électromagnétiques sont amenés à venir perturber le fonctionnement du circuit intégré 2 mis en fonctionnement par un circuit de commande et de contrôle 32. Ce circuit est par exemple un circuit du type de celui décrit dans le document US-B1-6 400 164. Le circuit de contrôle 32 est par ailleurs capable de mesurer le défaut de réponse du circuit intégré 2 lors d'une sollicitation du circuit intégré 2. Un compteur 33 sert à compter le nombre de défaillances qui se produisent dans le circuit intégré 2 au moment de ces perturbations.

Le circuit d'alimentation 8 comporte par ailleurs de préférence un coupleur 34 à 3 dB avec deux sorties de dérivation 35 et 36. La sortie 35 permet de mesurer la réalité de la puissance incidente Pi appliquée par l'antenne 9 sur les connexions 4. La sortie 36 permet de mesurer la puissance réfléchie Pr, du fait du défaut d'adaptation à l'impédance caractéristique de la charge formée par le circuit intégré 2. En agissant ainsi on est capable, en soustrayant la puissance réfléchie de la puissance incidente, de mesurer dans un appareil de mesure 37 la réalité de la puissance perturbatrice absorbée par les connexions 4 et le circuit intégré 2 au moment du test. On peut notamment à l'aide de l'appareil de mesure 37 juger de l'opportunité de placer ou non le deuxième cornet enveloppe 19 symétriquement au premier cornet enveloppe 11 de l'autre côté du circuit imprimé 3.

## Revendications

1. - Sonde (1) de test d'un circuit intégré (2) qui est porté par un circuit imprimé (3), la sonde comportant un générateur (5) de signaux radiofréquences, une antenne (9), un circuit (8) d'alimentation pour relier l'antenne au générateur, et des moyens pour disposer l'antenne en regard de connexions (4) situées en périphérie d'un circuit intégré à tester, pour faire rayonner (E, B) ces signaux radiofréquences sur ces connexions, **caractérisé en ce que** l'antenne comporte un guide d'onde avec un cornet enveloppe (11) et une âme masque (10), le cornet enveloppe ayant une surface d'ouverture (13) plus grande qu'une étendue d'une surface (14) d'un boîtier du circuit intégré à tester, l'âme masque ayant un épanouissement (16) dont une surface de section à l'endroit de son extrémité est inférieure à la surface d'un boîtier du circuit intégré à tester, des moyens étant prévus pour placer le cornet enveloppe contre le circuit imprimé, et l'âme masque, à l'intérieur du cornet enveloppe, au dessus du composant.

2. - Sonde selon la revendication 1, **caractérisée en ce que** le cornet enveloppe et l'âme masque sont formés par des surfaces conductrices de l'électricité.

3. - Sonde selon l'une des revendications 1 à 2, **caractérisée en ce que** l'âme masque comporte une cloche fermée ou une structure guide du champ, et un moyen (20) de connexion à un conducteur interne (17) d'un câble coaxial du circuit d'alimentation.

4. - Sonde selon l'une des revendications 1 à 3, **caractérisée en ce que** le cornet enveloppe est fait en deux demi-coquilles, symétriques l'une de l'autre par rapport à un plan passant par un grand axe (22) de révolution du cornet enveloppe.

5. - Sonde selon la revendication 4, **caractérisée en ce que** chaque demi coquille du cornet enveloppe comporte une demi-vasque (31) métallisée pour recevoir un conducteur externe (18) d'un câble coaxial du circuit d'alimentation.

6. - Sonde selon l'une des revendications 1 à 5, **caractérisée en ce que** qu'elle comporte un générateur (5) de signaux radioélectriques, réglable en fréquence (6) et en puissance (7), un circuit d'alimentation muni d'un coupleur (34), le coupleur servant à prélever (35, 36) une partie d'un signal transmis par le circuit d'alimentation et une partie d'un signal réfléchi à l'endroit du circuit intégré, et un appareil (37) de mesure pour mesurer une puissance effectivement absorbée.

7. - Sonde selon l'une des revendications 1 à 6, **caractérisée en ce que** qu'elle comporte un deuxième cornet enveloppe (19) placé symétriquement par rapport au cornet enveloppe, de l'autre côté du circuit imprimé qui porte le composant.

8. - Sonde selon l'une des revendications 1 à 7, **caractérisée en ce que** le cornet enveloppe comporte une jupe en tricot métallique munie à son bord inférieur d'un joint isolant (38) amovible, par exemple en caoutchouc.

9. - Sonde selon l'une des revendications 1 à 7, **caractérisée en ce que** le cornet enveloppe est en contact avec un plan de masse du circuit imprimé ou en appui sur des composants proches du circuit intégré testé.

## Claims

1. An integrated circuit (2) test probe (1) that is carried by a printed circuit (3), the probe comprising a radiofrequency signal generator (5), an antenna (9), a power circuit (8) to connect the antenna to the generator, and means to dispose the antenna opposite from the connections (4) situated in the periphery of an integrated circuit to be tested, to emit (E, B) these radiofrequency signals over these connections, **characterized in that** the antenna comprises a waveguide with a horn cover (11) and a core shield (10), the horn cover having an opening surface (13) that is larger than a span of a surface (14) of a housing of the integrated circuit to be tested, the core shield having a flaring (16) wherein one sectional surface at the location of its extremity is less at the surface of a housing of the integrated circuit to be tested, means being provided to place the horn cover against the printed circuit, and the core shield, inside the horn cover, above the component.

2. The probe according to claim 1, **characterized in that** the horn cover and the core shield are formed by electrically conductive surfaces.

3. The probe according to one of claims 1 to 2, **characterized in that** the core shield comprises a closed bell or a field guide structure, and a means (20) for connecting to an internal conductor (17) of a coaxial cable of the power circuit.

4. The probe according to one of claims 1 to 3, **characterized in that** the horn cover is made in two half-shells, symmetrical to each other with relation to a plane passing by a large rotation axis (22) of the horn cover.

5. The probe according to claim 4, **characterized in that** each half-shell of the horn cover comprises a metalized half-bowl (31) to receive an external conductor (18) of a coaxial cable of the power circuit.

6. The probe according to one of claims 1 to 5, **characterized in that** the probe comprises a radioelectric signal generator (5), adjustable in frequency (6) and in power (7), a power circuit equipped with a coupler (34), the coupler being used to retrieve (35, 36) a part of a signal transmitted by the power circuit and a part of a signal reflected at the location of the integrated circuit, and a measuring apparatus (37) to measure an effectively absorbed power.

7. The probe according to one of claims 1 to 6, **characterized in that** the probe comprises a second horn cover (19) placed symmetrically with relation to the horn cover, from the other side of the printed circuit that carries the component.

8. The probe according to one of claims 1 to 7, **characterized in that** the horn cover comprises a metallic knit skirt equipped at its lower edge with a removable insulated joint (38), for example in rubber.

9. The probe according to one of claims 1 to 7,
**characterized in that** the horn cover is in contact with a chip layout of the printed circuit or is pressed on the near components of the integrated circuit tested.

## Patentansprüche

1. Testsonde (1) einer integrierten Schaltung (2), die von einer gedruckten Schaltung (3) getragen wird, wobei die Sonde einen Generator (5) von Funkfrequenzsignalen, eine Antenne (9), eine Versorgungsschaltung (8), um die Antenne mit dem Generator zu verbinden, und Mittel umfasst, um die Antenne gegenüber von Anschlüssen (4) anzuordnen, die sich an der Peripherie einer zu testenden integrierten Schaltung befinden, um diese Funkfrequenzsignale an diesen Anschlüssen strahlen zu lassen (E, B), **dadurch gekennzeichnet, dass** die Antenne einen Wellenleiter mit einem Hüllenkegel (11) und einem Maskenkern (10) umfasst, wobei der Hüllenkegel eine größere Öffnungsfläche (13) als eine Ausdehnung einer Fläche (14) eines Gehäuses der zu testenden integrierten Schaltung hat, wobei der Maskenkern eine Ausbreitung (16) hat, deren eine Querschnittsfläche an der Stelle ihres Endes kleiner als die Fläche eines Gehäuses der zu testenden integrierten Schaltung ist, wobei Mittel vorgesehen sind, um den Hüllenkegel an der zu testenden integrierten Schaltung und den Maskenkern im Inneren des Hüllenkegels über der Komponente anzuordnen.

2. Sonde nach Anspruch 1, **dadurch gekennzeichnet, dass** der Hüllenkegel und der Maskenkern von den Strom leitenden Flächen gebildet sind.

3. Sonde nach einem der Ansprüche 1 bis 2, **dadurch gekennzeichnet, dass** der Maskenkern eine geschlossene Glocke oder eine Führungsstruktur des Feldes und ein Anschlussmittel (20) an einen inneren Leiter (17) eines Koaxialkabels der Versorgungsschaltung umfasst.

4. Sonde nach einem der Ansprüche 1 bis 3, **dadurch gekennzeichnet, dass** der Hüllenkegel aus zwei Halbschalen besteht, die zueinander und zu einer Ebene, die durch eine große Umdrehungsachse (22) des Hüllenkegels geht, symmetrisch sind.

5. Sonde nach Anspruch 4, **dadurch gekennzeichnet, dass** jede Halbschale des Hüllenkegels eine halbe metallisierte Wanne (31) umfasst, um einen externen Leiter (18) eines Koaxialkabels der Versorgungsschaltung aufzunehmen.

6. Sonde nach einem der Ansprüche 1 bis 5, **dadurch gekennzeichnet, dass** sie einen Generator (5) von funkelektrischen Signalen, der hinsichtlich der Frequenz (6) und der Leistung (7) einstellbar ist, eine Versorgungsschaltung, die mit einem Koppler (34) versehen ist, wobei der Koppler dazu dient, einen Teil eines von der Versorgungsschaltung übertragenen Signals und einen Teil eines an der Stelle der integrierten Schaltung reflektierten Signals zu entnehmen (35, 36), und ein Messgerät (37) zum Messen einer tatsächlich absorbierten Leistung umfasst.

7. Sonde nach einem der Ansprüche 1 bis 6, **dadurch gekennzeichnet, dass** sie einen zweiten Hüllenkegel (19) umfasst, der symmetrisch zum Hüllenkegel auf der anderen Seite der gedruckten Schaltung, die die Komponente trägt, angeordnet ist.

8. Sonde nach einem der Ansprüche 1 bis 7, **dadurch gekennzeichnet, dass** der Hüllenkegel eine Schürze aus metallischem Gewebe umfasst, die an ihrem unteren Rand mit einer abnehmbaren Isolierdichtung (38) beispielsweise aus Gummi versehen ist.

9. Sonde nach einem der Ansprüche 1 bis 7, **dadurch gekennzeichnet, dass** der Hüllenkegel mit einer Masseebene der gedruckten Schaltung in Kontakt ist oder auf nahen Komponenten der getesteten integrierten Schaltung aufliegt.
